# EUROPÄISCHE PATENTSCHRIFT

(11) **EP 1 699 089 B1**
(45) Veröffentlichungstag und Bekanntmachung des Hinweises auf die Patenterteilung: **23.04.2008**
(21) Anmeldenummer: 06003875.9
(22) Anmeldetag: 25.02.2006
(51) Int. Cl.: H01L 31/0203

(54) **Verfahren und Giessform zur Herstellung eines optischen Halbleitermoduls**
Method and mold for the manufacturing of an optical semiconductor modul
Méthode et moule pour la fabrication d'un module semiconducteur optique

(30) Priorität: 03.03.2005 DE 102005010311
(43) Veröffentlichungstag der Anmeldung: 06.09.2006
(73) Patentinhaber: ATMEL Germany GmbH, 74072 Heilbronn (DE)
(72) Erfinder: Mutz, Dieter, Dipl.-Ing.(FH), 74078 Heilbronn (DE); Waible, Hans-Peter, Dipl.-Ing., 74223 Flein (DE)
(74) Vertreter: Müller, Wolf-Christian

(56) Entgegenhaltungen:
- EP-A- 0 789 334
- EP-A- 1 220 309
- US-A- 5 811 799

## Beschreibung

Die Erfindung betrifft ein Verfahren und eine Gießform zur Herstellung eines optischen Halbleitermoduls, wobei ein Halbleitergrundkörper, der wenigstens ein optisch aktives Element an seiner Oberfläche aufweist, in einen Leadframe eingebracht wird, darauf leitende Verbindungen zwischen dem Halbleitergrundkörper und dem Leadframe hergestellt werden und darauf Leadframe und Halbleitergrundkörper in einer Gießform vergossen werden.

Es sind aus dem Stand der Technik derartige Herstellungsverfahren bekannt, bei denen ein optischer IC (PDIC) mit einer transparenten Vergussmasse umgossen beziehungsweise auf einem organischen Substrat angeordnet und dann mit einer Vergussmasse bedeckt wird. Die Vergussmasse muss transparent sein, um Strahlungen im optischen Bereich von oder zu dem optisch aktiven Element passieren zu lassen. Dabei muss die Vergussmasse auf den Wellenlängenbereich abgestimmt sein, in dem das optische Element sendet beziehungsweise empfängt. Zusätzlich muss die Vergussmasse temperaturstabil und langzeitstabil sowie feuchtigkeitsresistent sein.

Derartige Vergussmassen sind relativ teuer und es ergeben sich regelmäßig Probleme bei der optischen Transparenz.

Es sind deshalb aus dem Stand der Technik auch Verfahren zum Vergießen derartiger Halbleitermodule bekannt, bei denen durch entsprechende Gestaltung der Gießformen Teile der Oberfläche eines Halbleitergrundkörpers von der Vergussmasse freigehalten werden.

Aus der EP 1220309 ist beispielsweise bekannt, in einer Vergussform einen Hohlraum vorzusehen, der von einer an dem Halbleitermodul anliegenden Membran abgeschlossen wird. Die Membran kann durch Druckbeaufschlagung gegen die Oberfläche des Moduls gedrückt werden, um diese vom Verguß freizuhalten. Durch die Flexibilität der Membran soll eine vergußdichte Anpassung an die Lage des Moduls ermöglicht werden.

Aus der EP 0789334 A2 ist eine Gießform zum Vergießen eines Halbleitermoduls bekannt, bei der ein Abdeckkörper zum vergussdichten Abschluß an der Oberfläche des Halbleitermoduls vorgesehen ist, wobei der Abdeckkörper während des Vergusses flächig gegen das Modul gepreßt wird.

Der vorliegenden Erfindung liegt nun die Aufgabe zugrunde, die Nachteile des Standes der Technik zu vermeiden und ein Verfahren sowie eine Gießform zur Herstellung eines optischen Halbleitermoduls der eingangs genannten Art zu schaffen, bei dem eine kostengünstige Vergussmasse verwendet werden kann und die wünschenswerten optischen Eigenschaften des Halbleitermoduls möglichst zuverlässig und mit geringem Aufwand erreicht werden.

Erfindungsgemäß wird diese Aufgabe durch ein Verfahren mit den Merkmalen des Patentanspruchs 1 sowie durch eine Gießform mit den Merkmalen des Anspruchs 6 gelöst.

Durch das erfindungsgemäße Verfahren lässt sich in besonders einfacher und kostengünstiger Weise ein Halbleitermodul herstellen, das einerseits vergossen und dadurch vor Umwelteinflüssen wie Erschütterungen oder Feuchtigkeit geschützt ist, bei dem jedoch andererseits in dem Bereich, in dem Licht empfangen oder ausgesendet werden soll, die entsprechende Vergussmasse ausgenommen ist.

Um das Abdichten der zu schützenden optisch aktiven Bereiche des Halbleitergrundkörpers durch die Stirnfläche der Abdeckkörper zu erleichtern, ist vorgesehen, dass diese einen erhöhten Rand an ihrer Stirnseite aufweisen, der plan umläuft und eine Dichtkante in der Art einer Schneide gegenüber dem Halbleitergrundkörper bildet. Da die eigentliche Stirnfläche hinter diese Kante zurückgezogen ist, wird auch wirksam verhindert, dass durch Kapillarwirkung der Vergusswerkstoff in den Zwischenraum zwischen dem Halbleitergrundkörper und dem Abdeckkörper gezogen wird.

Dadurch kann eine kostengünstigere Vergussmasse, beispielsweise ein nicht optisch transparentes Epoxidharz, verwendet werden, was zu hoher Kostenersparnis führt. Die verwendeten Vergussmassen können dadurch auch nach anderen Kriterien ausgewählt werden als nach der optische Transmission und dadurch kann das Modul zusätzlich noch auf andere Bedürfnisse hin optimiert werden.

Vorzugsweise werden die Abdeckkörper in ihrer Größe so gewählt, dass sie ausreichende Bereiche des Halbleitergrundkörpers freilassen. Dabei kann jedem optisch aktiven Element auf dem Halbleitergrundkörper ein eigener Abdeckkörper zugeordnet sein oder mehrere der optisch aktiven Elemente können durch einen Abdeckkörper gemeinsam abgedeckt werden.

Nach dem Vergießen und weitgehenden Erstarren der Vergussmasse kann die Gießform jeweils geöffnet werden und die Abdeckkörper können mit dem der Oberseite des Halbleitergrundkörpers zugewandten Teil der Gießform herausgezogen werden. Die Stirnseiten der Abdeckelemente werden während des Gießvorgangs derart gegen den Halbleitergrundkörper gepresst, dass sich die dünnflüssige Vergussmasse nicht zwischen die Stirnseite des Abdeckkörpers und den entsprechenden Bereich des Halbleitergrundkörpers drängen kann.

Der Halbleitergrundkörper ist federnd in einem Leadframe gehalten, so dass bei entsprechender Länge der Abdeckkörper diese gegen die Federkraft den Halbleitergrundkörper ein Stück weit zurückdrücken können, um somit die entsprechende Andruckkraft zu erzeugen.

Besonders vorteilhaft ist es, wenn der Halbleitergrundkörper vor dem Verguss insgesamt auf seiner Oberseite mit einer Polyimidschicht bedeckt wird wobei die Bereiche der optisch aktiven Elemente freigelassen werden. Die Polyimidschicht hilft, den thermischen Stress auf den Halbleitergrundkörper in dem entstehenden Vergusskörper zu reduzieren und macht das Halbleitermodul temperaturstabiler und damit bei höheren Temperaturen einsetzbar. Dies ist besonders dann wichtig, wenn das Halbleitermodul mittels bleifreier Löttechnik weiter verarbeitet beziehungsweise mit anderen Schaltungseinheiten verbunden werden soll, da beim bleifreien Löten die entsprechenden Lote eine um etwa 20° C erhöhte Löttemperatur bei sonst gleichen Fügebedingungen erfordern.

Die erfindungsgemäße Gießform entspricht im wesentlichen von ihrem äußeren Aufbau her einer an sich bekannten Gießform für federnde Leadframes vom QFN-Typ (Quad flat non-leaded package), wobei zusätzlich die Abdeckkörper starr an einer Innenwand angeordnet und befestigt sind. Derartige Gießformen bestehen typischerweise aus Stahl und die Abdeckkörper können einstückig mit der Gießform verbunden sein.

Die Abdeckkörper können typischerweise als zylindrische Stifte ausgebildet werden, sie können jedoch auch leicht konisch zulaufen oder einen sich zum Halbleitergrundkörper hin stufenförmig, kegelförmig oder konvex oder konkav verringernden Querschnitt aufweisen, was die Entformung nach dem Vergussvorgang erleichtert. Jedenfalls weisen sie eine Stirnfläche mit einem umlaufend vorstehenden, planen Rand auf, der eine Schneide bildet, die gegen den Halbleitergrundkörper gedrückt werden kann. Im Querschnitt können die Abdeckkörper rund oder mehreckig, vorzugsweise viereckig, ausgebildet sein. Auch bei einer viereckigen Ausprägung können die Abdeckkörper zum Halbleitergrundkörper hin konisch zulaufen, um die Entformung zu erleichtern.

Das entstehende Halbleitermodul zeichnet sich durch seine einfache Machart und den geringen Preis aus, was durch den einfachen Verguss unter Freilassung der optisch aktiven Bereiche bedingt ist. Durch die entsprechenden Ausnehmungen im Vergusswerkstoff ist das Abstrahlen und Empfangen von optischen Signalen möglich. Durch eine Polyimidbeschichtung auf dem Halbleitergrundkörper ist das Halbleitermodul ausgesprochen temperaturstabil.

Im folgenden wird die Erfindung anhand eines Ausführungsbeispiels in einer Zeichnung gezeigt und anschließend beschrieben. Dabei zeigt:
- Figur 1: ein vergossenes Halbleitermodul im Querschnitt;
- Figur 2: das Modul aus Figur 1 in einer Ansicht von unten;
- Figur 3: das Modul aus den Figuren 1 und 2 in einer Seitenansicht;
- Figur 4: eine perspektivische teilweise durchbrochene Ansicht des Halbleitermoduls aus Figur 1;
- Figur 5: eine geschnitten perspektivische Ansicht des Moduls aus Figur 1;
- Figur 6: eine perspektivische Ansicht einer Gießform für ein Halbleitermodul in schematischer Darstellung;
- Figur 7: einen Schnitt durch einen Abdeckkörper in zylindrischer Form;
- Figur 8: einen Schnitt durch einen zylindrischen Abdeckkörper, der an seiner Stirnseite einen umlaufenden Steg aufweist;
- Figur 9: eine perspektivische Ansicht eines nicht zur Erfindung gehörenden, konisch kegelstumpfförmigen Abdeckkörpers;
- Figur 10: eine perspektivische Ansicht eines nicht zur Erfindung gehörenden, pyramidenstumpfförmigen Abdeckkörpers.

In den Figuren der Zeichnung sind gleiche beziehungsweise funktionsgleiche Elemente und Signale - sofern nichts anderes angegeben ist - mit den selben Bezugszeichen versehen worden.

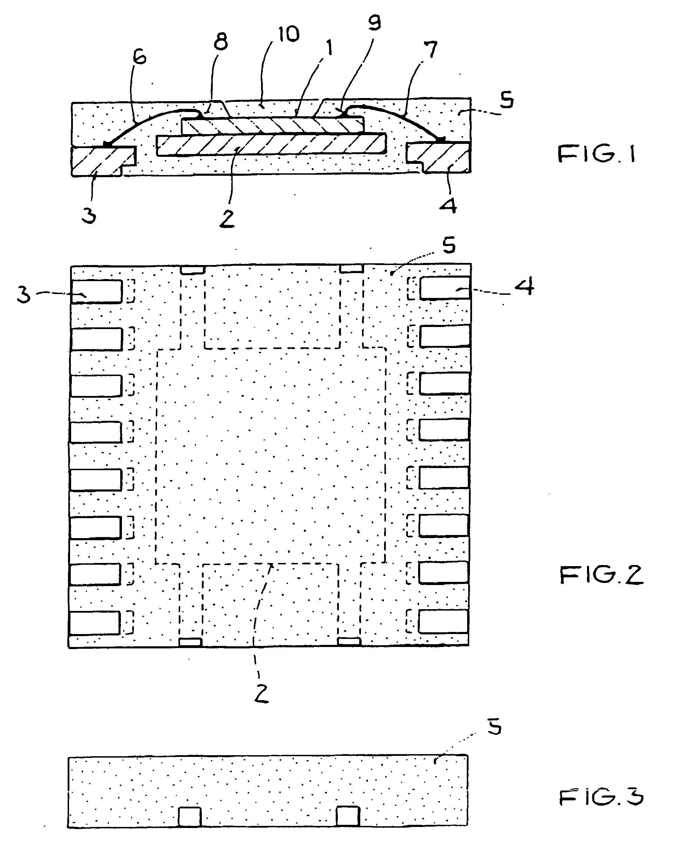

Die Figur 1 zeigt im Querschnitt ein vergossenes Halbleitermodul, bei dem ein Halbleitergrundkörper 1 auf einem Substrat 2 befestigt und diese Einheit auf einem Leadframe federnd gelagert ist, dessen Teile mit 3, 4 bezeichnet sind. Der Vergusswerkstoff, der typischerweise durch ein Epoxidharz gebildet ist, ist mit 5 bezeichnet. Die Teile 3, 4 des Leadframe bilden jeweils Einzelkontakte, die über Bonddrähte 6, 7 mit jeweiligen Bondflächen 8, 9 des Halbleitergrundkörpers verbunden sind. Die einzelnen Kontakte 3, 4 werden nach dem Verguss und dem Aushärten des Halbleitermoduls durch Sägen aus einem zusammenhängenden Metallkörper gebildet. Dieser besteht vor der Herstellung des Halbleitermoduls aus einem zusammenhängenden Rahmen einheitlichen Materials, beispielsweise Kupfer, bei dem durch Ätzen oder Vorstanzen Stellen gebildet sind, an denen sich die einzelnen Kontakte später einfach trennen lassen. Dadurch ist dieser Rahmen einfach verarbeitbar und kann dennoch später nach dem Vergießen in viele gegeneinander elektrisch isolierte Einzelteile zerlegt werden.

Die Figur 1 zeigt, dass der Halbleitergrundkörper 1 nur teilweise von dem Vergusswerkstoff 5 überdeckt ist. Es bleibt dabei ein Freiraum 10, in dem optisch aktive Elemente angeordnet sein können, die dann Strahlung aussenden oder empfangen können, ohne durch den Vergusswerkstoff 5 gehindert zu werden.

Nicht dargestellt in der Figur ist die Beschichtung des Halbleitergrundkörpers 1 mit einer dünnen Polyimidschicht, wobei der Bereich 10 sowie die Bereiche 8, 9, wo später gebondet wird, ausgenommen sind.

Das Substrat 2 kann beispielsweise durch eine Keramik, einen organischen Werkstoff oder auch ein Metall gebildet werden. Die Leitfähigkeit spielt dabei keine Rolle, da die elektrisch aktive Zone des Halbleitergrundkörpers sich ausschließlich an seiner Oberseite befindet.

Die Figur 2 zeigt das Halbleitermodul aus der Figur1 in einer Ansicht von unten, wo die vereinzelten Kontakte 3, 4 offen liegen und erkennbar sind.

Figur 3 zeigt eine Außenansicht des Halbleitermoduls von der Vorderseite.

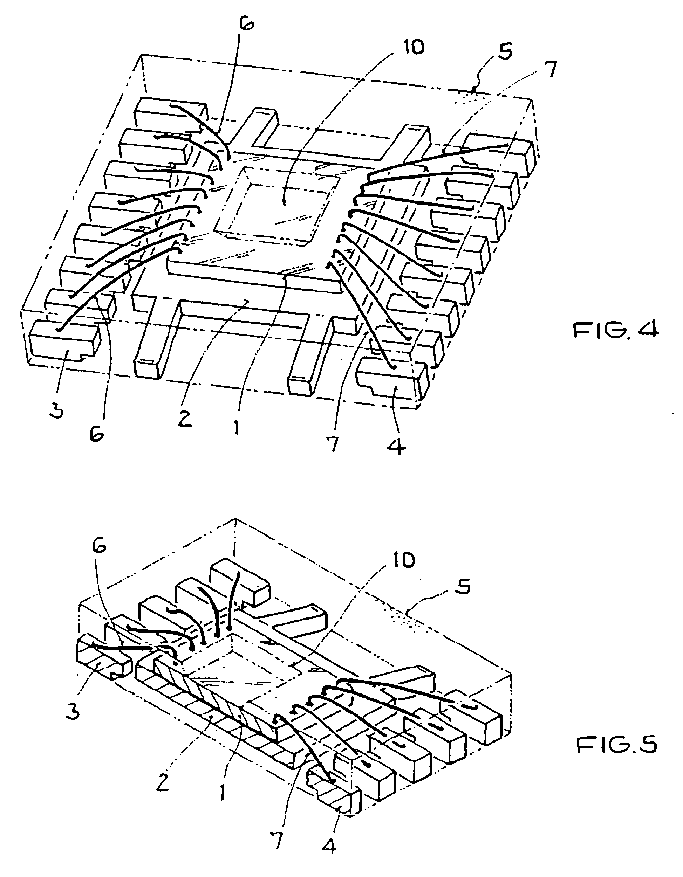

In der Figur 4 ist eine dreidimensionale Ansicht des Halbleitermoduls gezeigt, wobei der Vergusswerkstoff derart durchsichtig dargestellt ist, dass die Bonddrähte 6, 7 sowie die Teile des Leadframes sichtbar sind. Die Bonddrähte führen zu dem Halbleitergrundkörper 1, wo sie auf Bondflächen 8, 9 enden. Es ist eine Ausnehmung 10 in dem Vergusswerkstoff dargestellt, die die optisch aktiven Elemente des Halbleitergrundkörpers 1 zur Abstrahlung und zum Empfang von optischer Strahlung freilässt.

Die Figur 5 zeigt das Halbleitermodul aus der Figur 4 in einer geschnittenen dreidimensionalen Form.

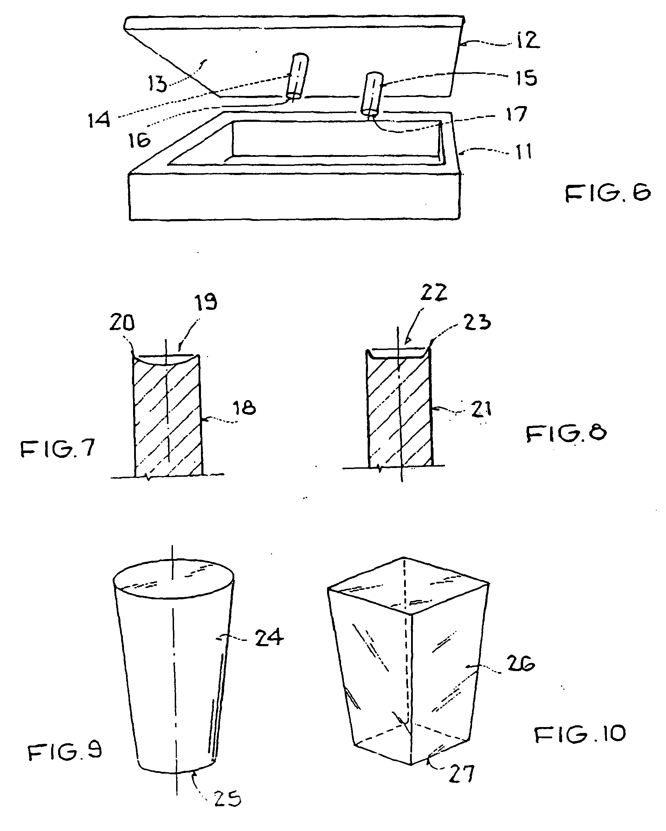

In der Figur 6 ist sehr schematisch eine Gießform 11, 12 für ein Halbleitermodul dargestellt. Derartige Gießformen sind typischerweise vielfach zusammengefasst, um mit einem Vergussvorgang möglichst viele Halbleitermodule zu schaffen, in der Figur ist jedoch nur eine einzige Form dargestellt, die aus einem Unterteil 11 und einem Oberteil 12 besteht. Das Oberteil 11 trägt an seiner Innenseite 13 zwei Abdeckkörper 14, 15, die als zylindrische Stäbe mit Stirnflächen 16, 17 ausgebildet sind.

Die Gießform wird nach Einlage des Leadframes und des Halbleitergrundkörpers auf dem Substrat, die bereits durch Bonden miteinander verbunden sind, zunächst geschlossen. Dabei stoßen die Abdeckkörper 14, 15 mit ihren Stirnflächen 16, 17 auf den Halbleitergrundkörper und decken auf diesem die optisch aktiven Bereiche ab. Nach dem Schließen der Gießform wird dann durch eine Einlassöffnung das bei hohen Temperaturen dünnflüssige Epoxidharz als Vergusswerkstoff eingefüllt, bis dass der Innenraum der Gießform 11, 12 gefüllt ist. Nach dem Erstarren des Gießharzes wird die Oberseite der Gießform 12 entfernt und die Abdeckkörper 14, 15 werden aus dem erhärteten Epoxidharz herausgezogen. Es verbleiben Öffnungen im Gießharz, die bis zum Halbleitergrundkörper reichen und dort die optisch aktiven Bereiche freilassen.

Die Figur 7 zeigt in einem Längsschnitt einen zylindrischen Abdeckkörper 18, der eine Stirnseite 19 mit einer muldenartigen Vertiefung aufweist, deren Rand 20 plan umläuft und eine Schneide bildet, die gegenüber dem Halbleitergrundkörper beim Verguss eine vergussdichte Abdeckung bildet.

Die Figur 8 zeigt einen weiteren Abdeckkörper 21, der ebenfalls zylindrisch ist und der an seiner Stirnseite 22 einen umlaufenden Steg 23 aufweist, der eine Dichtfläche gegenüber dem Halbleitergrundkörper bildet.

Die nicht zur Erfindung gehörende Figur 9 zeigt einen konisch zulaufenden Kegelstumpf 24, der eine plane Stirnseite 25 zum Aufsetzen auf den Halbleitergrundkörper aufweist, während die nicht zur Erfindung gehörende Figur 10 einen im Querschnitt viereckigen Kegelstumpf 26 mit einer planen Stirnseite 27 zeigt.

## Patentansprüche

1. Verfahren zur Herstellung eines optischen Halbleitermoduls bei dem ein Halbleitergrundkörper (1), der wenigstens ein optisch aktives Element aufweist, in einen Leadframe (3, 4) eingebracht wird,
wobei leitende Verbindungen zwischen dem Halbleitergrundkörper (1) und dem Leadframe (3, 4) hergestellt werden,
danach der Leadframe (3, 4) und der Halbleitergrundkörper (1) in einer Gießform (11, 12) vergossen werden,
wobei wenigstens ein mit der Gießform starr verbundener Abdeckkörper (14, 15, 18, 21) vorgesehen ist, der sich von der Innenwand der Gießform (11, 13) bis zu dem optisch aktiven Element erstreckt und der während des Vergusses gegen den Halbleitergrundkörper (1) gedrückt wird, der seinerseits gegen den federnd nachgebenden Leadframe (3,4) gedrückt wird, und
wobei der Abdeckkörper mit einem an seiner Stirnseite umlaufend vorstehenden planen Rand, der eine Schneide bildet, mit dem Halbleitergrundkörper (1) vergussdicht abschließt.

2. Verfahren nach Anspruch 1,
**dadurch gekennzeichnet,dass**
der Verguss mit einem im Wellenlängenbereich der optisch aktiven Elemente nicht transparenten Vergusswerkstoff (5) insbesondere einem Epoxidharz durchgeführt wird.

3. Verfahren nach einem der vorangegangenen Ansprüche,
**dadurch gekennzeichnet, dass**
der Verguss mit einem im Wellenlängenbereich der optisch aktiven Elemente transparenten Vergusswerkstoff (5), insbesondere einem Epoxidharz, durchgeführt wird.

4. Verfahren nach einem der vorangegangenen Ansprüche,
**dadurch gekennzeichnet, dass**
bei dem Verguß Abdeckkörper (14, 15, 18, 21) aus einem transparenten Werkstoff eingesetzt werden.

5. Verfahren nach einem der vorangegangenen Ansprüche,
**dadurch gekennzeichnet, dass**
der Halbleitergrundkörper (1) vor dem Einbringen in den Leadframe (3, 4) unter Ausnehmung der optisch aktiven Elemente mit einem Polyimid beschichtet wird.

6. Gießform zur Verwendung in einem Verfahren zur Herstellung eines optischen Halbleitermoduls bei dem ein Halbleitergrundkörper (1), der wenigstens ein optisch aktives Element aufweist, in einen Leadframe (3, 4) eingebracht wird,
wobei leitende Verbindungen zwischen dem Halbleitergrundkörper (1) und dem Leadframe (3, 4) hergestellt werden, danach der Leadframe (3, 4) und der Halbleitergrundkörper (1) in einer Gießform (11, 12) vergossen werden, wobei wenigstens ein Abdeckkörper (14, 15, 18, 21) vorgesehen ist, der sich zwischen Innenwand der Gießform (11, 13) und dem optisch aktiven Element befindet
**dadurch gekennzeichnet, dass**
an einer der Oberseite des Halbleitergrundkörpers (1) zugewandten Innenwand der Gießform wenigstens ein Abdeckkörper (14, 15, 18, 21)starr befestigt ist, der/die sich mit ihrer jeweiligen Stirnfläche(n) (16, 17, 19, 22) bis zur Oberfläche des Halbleitergrundkörpers (1) erstreckt /(en) und dass die Stirnfläche (16, 17, 19, 22) wenigstens eines der Abdeckkörper (14, 15, 18, 21) einen umlaufend vorstehenden planen Rand (20, 23) aufweist, der eine Schneide bildet und der mit der Oberfläche des Halbleitergrundkörpers vergussdicht abschließt und hinter den der innere Bereich der Stirnfläche zurückgezogen ist.

7. Gießform nach Anspruch 6,
**dadurch gekennzeichnet, dass**
die Abdeckkörper (14, 15, 18, 21) entlang ihrer Länge gleichbleibende Querschnittsfläche aufweisen.

8. Gießform nach Anspruch 6,
**dadurch gekennzeichnet,dass**
die Abdeckkörper (14, 15, 18, 21) entlang ihrer Länge einen sich stufenförmig, kegelschnittförmig, konvex oder konkav zum Halbleitergrundkörper (1) hin verringernden Querschnitt, aufweisen.

9. Gießform nach Anspruch 7 oder 8,
**dadurch gekennzeichnet,dass**
die Abdeckkörper (14, 15, 18, 21) im Querschnitt rund ausgebildet sind.

10. Gießform nach einem der Ansprüche 7 oder 8,
**dadurch gekennzeichnet,dass**
die Abdeckkörper (14, 15, 18, 21) im Querschnitt viereckig ausgebildet sind.

## Claims

1. Method of producing an optical semiconductor module in which a semiconductor base body (1), which has at least one optically active element, is mounted in a lead frame (3, 4), wherein conductive connections between the semiconductor base body (1) and the lead frame (3, 4) are produced, the lead frame (3, 4) and the semiconductor base body (1) are thereafter cast in a casting mould (11, 12), wherein at least one cover body (14, 15, 18, 21) rigidly connected with the casting mould is provided, which body extends from the inner wall of the casting mould (11, 13) up to the optically active element and is pressed during the casting against the semiconductor base body (1), which in turn is pressed against the resiliently yielding lead frame (3, 4), and wherein the cover body closes in casting-tight manner with the semiconductor base body (1) by a protruding planar edge which encircles at the end face of the cover body and forms a cutting edge.

2. Method according to claim 1, **characterised in that** the casting is carried out with a casting material (5), particularly an epoxy resin, which is non-transparent in the wavelength range of the optically active elements.

3. Method according to one of the preceding claims, **characterised in that** the casting is carried out with a casting material (5), particularly an epoxy resin, which is transparent in the wavelength range of the optically active elements.

4. Method according to one of the preceding claims, **characterised in that** cover bodies (14, 15, 18, 21) of a transparent material are used in the casting.

5. Method according to one of the preceding claims, **characterised in that** the semiconductor base body (1) is coated, with the exception of the optically active elements, with a polyimide prior to introduction into the lead frame (3, 4).

6. Casting mould for use in a method for producing an optical semiconductor module in which a semiconductor base body (1), which comprises at least one optically active element, is introduced into a lead frame (3, 4) wherein conductive connections are produced between the semiconductor base body (1) and the lead frame (3, 4), thereafter the lead frame (3, 4) and the semiconductor base body (1) are cast in a casting mould (11, 12), wherein at least one cover body (14, 15, 18, 21) is provided, which is disposed between the inner wall of the casting mould (11, 13) and the optically active element, **characterised in that** at least one cover body (14, 15, 18, 21), which extends by its respective end surface (16, 17, 19, 22) up to the surface of the semiconductor body (1), is rigidly fastened to an inner wall, which faces the upper side of the semiconductor base body (1), of the casting mould, and that the end surface (16, 17, 19, 22) of at least one of the cover bodies (14, 15, 18, 21) has an encircling, protruding planar edge (20, 23), which forms a cutting edge and which closes in casting-tight manner with the surface of the semiconductor base body and behind which the inner region of the end surface is drawn back.

7. Casting mould according to claim 6, **characterised in that** the cover bodies (14, 15, 18, 21) have the same cross-sectional area along their length.

8. Casting mould according to claim 6, **characterised in that** the cover bodies (14, 15, 18, 21) have along the length thereof a cross-section reducing in step-shaped, conic, convex or concave manner towards the semiconductor base body (1).

9. Casting mould according to claim 7 or 8, **characterised in that** the cover bodies (14, 15, 18, 21) are formed to be round in cross-section.

10. Casting mould according to one of claims 7 and 8, **characterised in that** the cover bodies (14, 15, 18, 21) are formed to be quadrangular in cross-section.

## Revendications

1. Procédé de fabrication d'un module optique semi-conducteur dans lequel on introduit un substrat semi-conducteur (1) présentant au moins un élément optique actif dans une grille de connexion (3,4),
dans lequel on réalise des connexions conductrices entre le substrat semi-conducteur (1) et la grille de connexion (3,4),
dans lequel on coule ensuite la grille de connexion (3,4) et le substrat semi-conducteur (1) dans un moule (11,12),
dans lequel on prévoit au moins un corps formant couvercle (14,15,18,21) relié de manière rigide au moule qui s'étend de la paroi interne du moule (11,13) jusqu'à l'élément optique actif et qui durant le moulage est pressé contre le substrat semi-conducteur (1) qui se trouve lui-même pressé contre la grille de connexion (3,4) élastique, et
dans lequel le corps formant couvercle réalise une fermeture étanche au moulage par rapport au substrat semi-conducteur (1) par un bord plan périphérique en saillie de sa face frontale formant un tranchant.

2. Procédé selon la revendication 1, **caractérisé en ce que** le moulage est effectué avec un matériau de moulage (5) non transparent dans la zone des longueurs d'onde des éléments optiques actifs, plus particulièrement avec une résine époxy.

3. Procédé selon l'une quelconque des revendications précédentes, **caractérisé en ce que** le moulage est effectué avec un matériau de moulage (5) transparent dans la zone des longueurs d'onde des éléments optiques actifs, plus particulièrement avec une résine époxy.

4. Procédé selon l'une quelconque des revendications précédentes, **caractérisé en ce que** durant le moulage on met en place des corps formant couvercle (14,15,18,21) réalisés dans un matériau transparent.

5. Procédé selon l'une quelconque des revendications précédentes, **caractérisé en ce que** l'on enduit le substrat semi-conducteur (1) d'un polyimide avant son introduction dans la grille de connexion (3,4) à l'exception des éléments optiques actifs.

6. Moule destiné à être utilisé dans un procédé de fabrication d'un module optique semi-conducteur dans lequel un substrat semi-conducteur (1) présentant au moins un élément optique actif est introduit dans une grille de connexion (3,4) dans lequel on réalise des connexions conductrices entre le substrat semi-conducteur (1) et la grille de connexion (3,4) dans lequel la grille de connexion (3,4) et le substrat semi-conducteur (1) sont ensuite coulés dans un moule (11,12), dans lequel on prévoit au moins un corps formant couvercle (14,15,18,21) situé entre la paroi interne du moule (11,13) et l'élément optique actif, **caractérisé en ce qu'**au moins un corps formant couvercle (14,15,18,21) est fixé rigidement à une paroi interne du moule en regard de la face supérieure du substrat semi-conducteur (1), s'étendant par sa (leur) face(s) frontale(s) respective(s) (16,17,19,22) jusqu'à la face supérieure du substrat semi-conducteur (1), et **en ce que** la face frontale (16,17,19,22) d'au moins un des corps formant couvercle (14,15,18,21) présente un bord plan périphérique en saillie (20,23) formant un tranchant et qui réalise une fermeture étanche au moulage avec la face supérieure du substrat semi-conducteur et derrière lequel la zone intérieure de la face frontale est rétractée.

7. Moule selon la revendication 6, **caractérisé en ce que** les corps formant couvercle (14,15,18,21) présentent sur leur longueur des surfaces de section constantes.

8. Moule selon la revendication 6, **caractérisé en ce que** les corps formant couvercle (14,15,18,21) présentent sur leur longueur une section allant en se réduisant en direction du substrat semi-conducteur (1) de manière étagée, conique, convexe ou concave.

9. Moule selon la revendication 7 ou 8, **caractérisé en ce que** les corps formant couvercle (14,15,18,21) présentent une section ronde.

10. Moule selon l'une quelconque des revendications 7 ou 8, **caractérisé en ce que** les corps formant couvercle (14,15,18,21) présentent une section carrée.
